Europäisches Patentamt

European Patent Office

Office européen des brevets

(11) Veröffentlichungsnummer: **0 191 371 B1**

(12) **EUROPÄISCHE PATENTSCHRIFT**

(45) Veröffentlichungstag der Patentschrift: **19.09.90**

(21) Anmeldenummer: **86101198.9**

(22) Anmeldetag: **30.01.86**

(51) Int. Cl.⁵: **B 42 F 15/00**, B 42 F 15/06

(54) **Schrank zum geordneten Aufbewahren von Montagefolien zur Herstellung von Druckplatten.**

(30) Priorität: **07.02.85 DE 3504081**

(43) Veröffentlichungstag der Anmeldung:
**20.08.86 Patentblatt 86/34**

(45) Bekanntmachung des Hinweises auf die
Patenterteilung:
**19.09.90 Patentblatt 90/38**

(84) Benannte Vertragsstaaten:
**FR GB IT**

(56) Entgegenhaltungen:
**EP-A-0 004 827**
**DE-A-2 450 284**
**DE-C- 869 680**

(73) Patentinhaber: **Kieper, Horst**
**Kaiser-Wilhelm-Allee 15**
**D-5600 Wuppertal 1 (DE)**

(72) Erfinder: **Kieper, Horst**
**Kaiser-Wilhelm-Allee 15**
**D-5600 Wuppertal 1 (DE)**

(74) Vertreter: **Spalthoff, Adolf, Dipl.-Ing.**
**Pelmanstrasse 31 Postfach 34 02 20**
**D-4300 Essen 1 (DE)**

Courier Press, Leamington Spa, England.

Beschreibung

Die Erfindung betrifft einen Schrank zum geordneten Aufbewahren von Montagefolien zur Herstellung von Druckplatten, welche Lochungen längs ihres oberen Randes aufweisen und mit diesen in der Aufbewahrungsstellung des Schrankes auf zwei Reihen von waagerecht angeordneten frei vorragenden Bolzen aufgeschoben sind, wobei die Bolzen der einen Reihe an einem feststehenden Teil des Schrankes und die Bolzen der anderen Reihe an einem verschiebbaren Teil des Schrankes angebracht sind und der verschiebbare Teil und der feststehende Teil des Schrankes mittels Gleit- oder Rollenführungen teleskopartig miteinander verbunden sind.

Derartige Schränke zur Aufbewahrung von Zeichnungen sind beispielsweise bekannt durch die EP 0004 827 B1. Bei dem durch diese patentschrift bekanntgewordenen Schrank liegen die Bolzen der beiden Reihen einander paarweise gegenüber oder beinahe gegenüber und sind so angeordnet, daß in der Aufhängestellung der Zeichnungen diese stets durch wenigstens einen der beiden Bolzen eines Paares von gegenüberliegenden Bolzen aufgehängt sind. Die Bolzen der einen Reihe stehen fest, während die Bolzen der anderen Reihe durch Verschiebung ihres freien Endes gegenüber dem freien Ende der entsprechenden feststehenden Bolzen einen bestimmten Abstand bilden. Dieser Abstand ermöglicht den Durchgang der Zeichnungen für ihr Aufhängen, ihr Anheben nach dem Aussuchen sowie ihr Zurückbringen auf die Bolzen.

Diese bekannten Schränke haben wegen der starren Anordnung ihrer Bolzen und der Einfachlochung der Zeichnungsränder den Nachteil, daß die Zeichnungen praktisch nur mit dem Rand einer Lochung auf einem der Bolzen aufliegen, was zu einer sehr starken Beanspruchung des Randes der Lochung führt. Dieses fällt beim Aufbewahren von Zeichnungen nicht gravierend ins Gewicht, weil die Einfachlochung sich sowieso nur an den Hefträndern der Zeichnungen befindet.

Wesentlich schwieriger gestaltet sich jedoch die geordnete Aufbewahrung von Montagefolien zur Herstellung von Druckplatten, was durch Kopieren erfolgt. Diese Montagefolien sind an zwei einander gegenüberliegenden Rändern mit einer Vielzahl von Lochungen versehen, welche der Justierung der Montagefolien beim Kopieren der Druckplatten dienen. Eine solche Montage'folie besteht üblicherweise aus einer durchsichtigen Kunststoffolie, auf die der Drucksatz montiert ist. Für einen 4-farbigen Druck sind vier Montagefolien erforderlich, die sich bei ihrer Lagerung nicht mäßlich verändern dürfen, da ein Rasterpunkt beispielsweise nur 3/100 mm groß ist und bei einer Verschiebung sich im Druck kein Kontrast mehr bildet. Die vorerwähnten Schränke sind somit zur geordneten Aufbewahrung von Montagefolien der hier in Rede stehenden Art nicht geeignet.

Von diesem Stand der Technik ausgehend liegt der Erfindung die Aufgabe zugrunde, unter Vermeidung vorerwähnter Nachteile, einen Schrank der eingangs genannten Art zu schaffen, welcher eine geordnete Aufbewahrung von Montagefolien zur Herstellung von Druckplatten derart ermöglicht, daß diese mit ihren sämtlichen Lochrändern an einer Seite der Folien auf den Bolzen aufliegen, so daß diese insgesamt die Montagefolien tragen.

Erfindungsgemäß wird dies dadurch erreicht, daß mindestens an einem der Teile des Schrankes zwei oder mehrere im wesentlichen C-förmigen Querschnitt aufweisende Aufnahmen vorgesehen sind, in denen mit Bewegungsspiel jeweils eine Platte angeordnet ist, welche fest mit einem der vorragenden Bolzen verbunden ist, wobei die Aufnahmen mit ihren Stegen an den Teilen des Schrankes befestigt sind und in ihren oberen und unteren Schenkeln eine oder mehrere Gewindebohrungen besitzen, in die Gewindebolzen eingeschraubt sind, deren Stirnseiten den oberen bzw. unteren Stirnseiten der Platten zugeordnet sind und die Abbiegungen der oberen und unteren Schenkel der Aufnahmen mit einer oder mehreren Gewindebohrungen ausgerüstet sind, in die Gewindebolzen eingeschraubt sind, deren Stirnseiten den Vorderseiten der Platten zugeordnet sind. Aufgrund des reichlich bemessenen Bewegungsspiels der Platten innerhalb der Hohlräume der Aufnahmen in Verbindung mit den die Aufnahmen durchsetzenden Schraub- sowie Gewindebolzen, lassen sich die Platten und damit die mit diesen verbunden Bolzen sowohl in horizontaler als auch in vertikaler Richtung verschieben, so daß eine einwandfreie Justierung der einzelnen Bolzen möglich ist, mit der Folge, daß die Bolzen einer jeden Reihe an den oberen Bereichen der Lochränder anliegen und somit sämtliche Bolzen die Montagefolien mittragen. Ein Längen der Montagefolien in Folge eines Durchhängens ist damit, selbst über einen längeren Zeitraum, ausgeschlossen.

Vorteilhaft sind die oberen und/oder unteren Bereiche der Platten von Schraubbolzen durchsetzt, deren Köpfe sich mit Bewegungsspiel in Durchtrittsbohrungen in den Abbiegungen der oberen und/oder unteren Schenkel der Aufnahmen erstrecken. Mit Hilfe dieser Schraubbolzen lassen sich die platten in einem Winkel zu ihren Aufnahmen einstellen, so daß die Bolzen leicht aufwärts oder abwärts gerichtet sein können, je nachdem wie es die jeweiligen Gegebenheiten erfordern. Auf jeden Fall ist durch diese zusätzliche Einstellmöglichkeit Gewähr dafür gegeben, daß sämtliche Lochungsränder der Montagefolien auf den Bolzen mittragen.

Im oberen und unteren Schenkel einer jeden Aufnahme ist mittig jeweils eine Gewindebohrung zur Höheneinstellung der platten vorgesehen.

In den Abbiebungen des oberen und unteren Schenkels einer jeden Aufnahme ist symmetrisch zueinander jeweils ein Paar von Gewindebohrungen vorhanden, zwischen die sich jeweils eine Durchtrittsbohrung für die Schraubbolzen der platten befindet. Durch diese Ausgestaltung ergibt sich eine völlig symmetrische Verschiebung der Platten in waagerechter Richtung.

Gemäß einem weiteren Merkmal der Erfindung können sich die freien Enden der Bolzen sich in diesen angepaßte Ausnehmungen von Platten erstrecken, die sich in am gegenüberliegenden Teil des Schrankes befestigten Aufnahmen befinden. Auf diese Weise ist es möglich, in der Aufbewahrungsstellung des Schrankes auch die frei vorragenden Spitzen der Schraubbolzen festzulegen, so daß eine sichere Auflage der Lochränder auf dem Bolzen, auch über längere Zeiträume, sichergestellt ist.

Vorteilhaft sind die Aufnahmen beider Teile des Schrankes gleich ausgeführt, so daß das System mit nur wenigen Einzelteilen zu verwirklichen ist.

Nach einem weiteren Merkmal der Erfindung sind die Bolzen einer Reihe derart gestaltet, daß mindestens jeweils einer an verschiedenen Randbereichen der Lochungen anliegt. So können einzelne Bolzen mit ihren äußeren Umflächen jeweils an den oberen und unteren sowie an den linken und rechten Bereichen der Lochränder der Montagefolien anliegen, wodurch erreicht wird, daß diese auf den Bolzen nicht verrutschen können und somit auch die auf den Oberflächen der Montagefolien vorhandenen Fotoschichten nicht beschädigt werden können, weil benachbarte Montagefolien nicht mehr aneinanderreiben können.

Die Form der Lochungen der Montagefolien ist beliebig.

Zur Erzielung einer möglichst hohen Genauigkeit empfiehlt es sich, die Stanzung der Montagefolien in einer sogenannten Komplettstanzung durchzuführen, in welcher alle Löcher an einem Rand der Folie in einem Stanzvorgang hergestellt werden.

Ein Ausführungsbeispiel der Erfindung ist an Hand der Zeichnung näher erläutert, und zwar zeigt:.

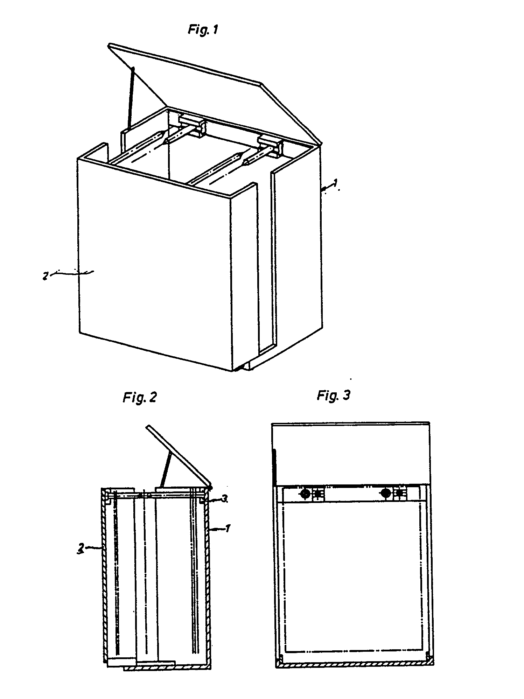

Fig. 1 eine Ansicht des Schrankes in schaubildlicher Darstellung,

Fig. 2 eine geschnittene Seitenansicht der Fig. 1,

Fig. 3 eine Vorderansicht des feststehenden Teils des Schrankes,

Fig. 4 eine Vorderansicht zweier benachbarter Aufhängungen eines Schrankteils,

Fig. 5 eine geschnittene Seitenansicht der einen Aufhängung der Fig. 4,

Fig. 6 eine geschnittene Seitenansicht der anderen Aufhängung der Fig. 4,

Fig. 7 eine Draufsicht der Fig. 4 und

Fig. 8 verschiedene Querschnittsformen von Lochungen sowie Bolzen.

Der Schrank zum geordneten Aufbewadren von Montagefolien weist einen feststehenden Teil 1 sowie einen verschiebbaren Teil 2 auf, welche in an sich bekannter Weise mittels nicht weiter dargestellter Gleit- oder Rollenführungen teleskopartig miteinander verbunden sind.

An beiden Teilen 1 und 2 des Schrankes befinden sich in deren oberen Bereichen Reihen von frei vorragenden Bolzen 5, 11, welche sich in einer und derselben Ebene erstrecken.

Zur Befestigung der Bolzen 5, 11 sind an den beiden Teilen 1,2 des Schrankes im wesentlichen C-förmigen Querschnitt aufweisende Aufnahmen 3 vorgesehen. In den Aufnahmen 3 ist mit Bewegungsspiel jeweils eine Platte 4 angeordnet, welche fest mit einem der vorragenden Bolzen 5 bzw. 11 verbunden ist.

Die Aufnahmen 3 sind mit ihren senkrechten Stegen 16 an den Teil 1,2 des Schrankes befestigt. In ihren oberen und unteren Schenkeln 17, 18 besitzen diese je eine Gewindebohrung 19. Im diese sind die Gewindebolzen 7, 9 bzw. 13, 15 eingeschraubt. Die Stirnseiten der Gewindebolzen 9, 15 sind den oberen Stirnseiten der Platten 4, 10 zugeordnet, während die der Gewindebolzen 7, 13 an den unteren Stirnseiten der Platten 4 bzw. 10 anliegen.

Die Abbiegungen 20, 21 der Schenkel 17 und 18 der platten 4 bzw. 10 sind mit Gewindebohrungen 22 ausgerüstet, in die Gewindebolzen 6 bzw. 12 eingeschraubt sind, deren Stirnseiten den Vorderseiten der Platten 4 bzw. 10 zugeordnet sind.

Die oberen und unteren Bereiche der platten 4 bzw. 10 sind von Schraubbolzen 8 bzw. 14 durchsetzt, deren Köpfe sich mit Bewegungsspiel in Durchtrittsbohrungen 23 in den Abbiegungen 20, 21 erstrecken.

Im oberen und unteren Schenkel 17, 18 einer jeden Aufnahme 3 ist mittig jeweils eine Gewindebohrung 19 vorgesehen.

In den Abbiegungen 20, 21 des oberen und unteren Schenkels 17, 18 einer jeden Aufnahme 3 ist symmetrisch zueinander jeweils ein paar von Gewindebohrungen 22 vorhanden, zwischen denen sich jeweils eine Durchtrittsbohrung 23 befindet.

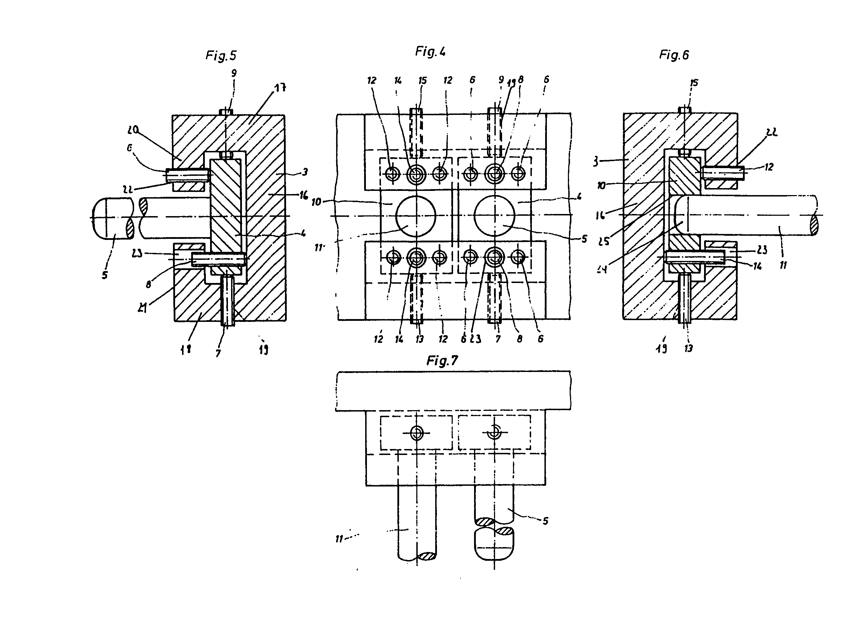

Wie insbesondere aus Fig. 6 ersichtlich, ist es auch möglich, daß die freien Enden 24 der Bolzen 5, 11 sich in deren Formgebung angepaßte Ausnehmungen 25 von platten 10 erstrecken, die sich in am gegenüberliegenden Teil 1 bzw. 2 des Schrankes befestigten Aufnahmen 3 befinden. Durch diese Ausgestaltung ist es möglich, auch die freien Enden 24 der Bolzen 5, 11 an dem jeweils gegenüberliegenden Teil 1 bzw. 2 des Schrankes festzulegen.

Die Aufnahmen 3 beider Schrankteile 1, 2 sind gleich ausgeführt, so daß das ganze System nur über wenige Einzelteile verfügt.

Aufgrund der erfindungsgemäßen Ausgestaltung ist es möglich, die Platten 4 bzw. 10 in den Aufnahmen 3 sowohl in horizontaler als auch in vertikaler Richtung über die zugehörigen Gewindebolzen zu verschieben und außerdem eine Winkelstellung einzustellen, so daß jede gewünschte Lage der Bolzen 5 bzw. 11 möglich ist und damit eine tragende Funktion aller Lochränder der Montagefolie.

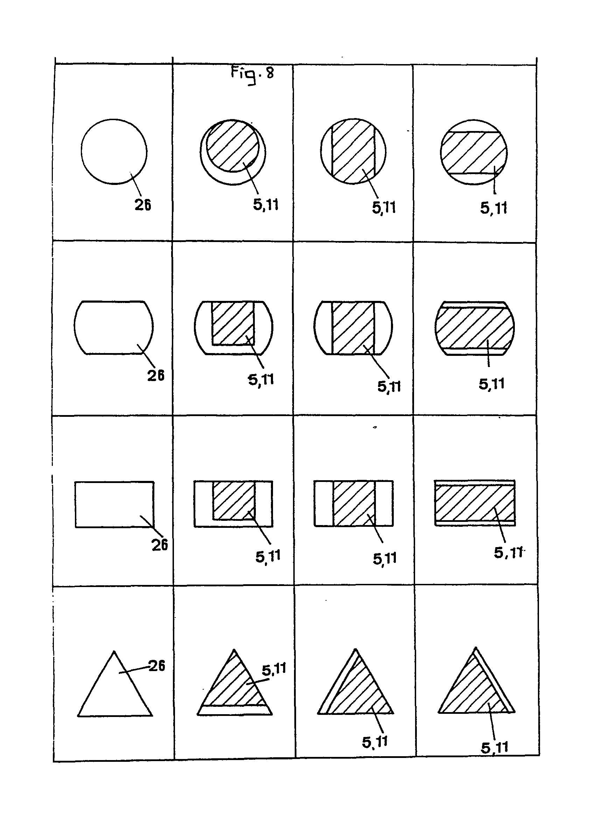

Wie aus Fig. 8 ersichtlich, können die Lochungen 26 in den Montagefolien verschiedene Querschnittformen besitzen.

Die Bolzen 5 bzw. 11 sind diesen in ihrer Formgebung so angepaßt, daß jeweils die oberen Bereiche der Ränder der Lochungen 26 auf diesen aufliegen. Diese Anordnung ergibt sich aus der zweiten Spalte von links der Fig. 8.

Um ein unbeabsichtigtes Verschieben der aufgehängten Montagefolien und damit ein Reiben der Oberflächen benachbarter Folien aneinander zu vermeiden, sind erfindungsgemäß die Bolzen 5 bzw. 11 einer Reihe derart gestaltet, daß mindestens jeweils einer an verschiedenen Randbereichen der Lochungen 26 anliegt. Dies ergibt sich aus der dritten und linken Spalte von links der Fig. 8 für die einzelnen Querschnittsformen der Lochungen 26.

**Patentansprüche**

1. Schrank zum geordneten Aufbewahren von Montagefolien zur Herstellung von Druckplatten, welche Lochungen (26) längs ihres oberen Randes aufweisen und mit diesen in der Aufbewahrungsstellung des Schrankes auf zwei Reihen von waagerecht angeordneten sich in einer und derselben Ebene erstreckenden frei vorragenden Bolzen (5, 11) aufgeschoben sind, wobei die Bolzen (5, 11) der einen Reihe an einem feststehenden Teil (1) des Schrankes und die Bolzen der anderen Reihe an einem verschiebbaren Teil (2) des Schrankes angebracht sind und der verschiebbare Teil (2) und der feststehende Teil (1) des Schrankes teleskopartig miteinander verbunden sind, dadurch gekennzeichnet daß die Führungen der teleskopartigen Verbindung Gleit- oder Rollenführungen sind und daß mindestens an einem der Teile (1, 2) des Schrankes zwei oder mehrere im wesentlichen C-förmigen Querschnitt aufweisende Aufnahmen (3) vorgesehen sind, in denen mit Bewegungsspiel jeweils eine Platte (4) bzw. (10) angeordnet ist, welche fest mit einem der vorragenden. Bolzen (5) bzw. (11) verbunden ist, wobei die Aufnahmen (3) mit ihren Stegen (16) an den Teilen (1, 2) des Schrankes befestigt sind und in ihren oberen und unteren Schenkeln (17, 18) eine oder mehrere Gewindebohrungen (19) besitzen, in die Gewindebolzen (7, 9) bzw (13, 15) eingeschraubt sind, deren Stirnseiten den oberen bzw. unteren Stirnseiten der Platten (4) bzw. (10) zugeordnet sind und die Abbiegungen (20, 21) der oberen und unteren Schenkel (17, 21) der Aufnahmen (3) mit einer oder mehreren Gewindebohrungen (22) ausgerüstet sind, in die Gewindebolzen (6) bzw. (12) eingeschraubt sind, deren Stirnseiten den Vorderseiten der Platten (4) bzw. (10) zugeordnet sind.

2. Schrank nach Anspruch 1, dadurch gekennzeichnet, daß die oberen und/oder unteren Bereiche der Platten (4) bzw. (10) von Schraubbolzen (8) bzw. (14) durchsetzt sind, deren Köpfe sich mit Bewegungsspiel in Durchtrittsbohrungen (23) in den Abbiegungen (20, 21) der oberen und/oder unteren Schenkel (17, 18) der Aufnahmen (3) erstrecken.

3. Schrank nach Anspruch 1 oder 2, dadurch gekennzeichnet, daß im oberen und unteren Schenkel (17, 18) einer jeden Aufnahme (3) mittig jeweils eine Gewindebohrung (19) vorgesehen ist.

4. Schrank nach Anspruch 1 oder einem der vorhergehenden, dadurch gekennzeichnet, daß in den Abbiegungen (20, 21) des oberen und unteren Schenkels (17, 18) einer jeden Aufnahme (3) symmetrisch zueinander jeweils ein Paar von Gewindebohrungen (22) vorhanden ist, zwischen denen sich jeweils eine Durchtrittsbohrung (23) befindet.

5. Schrank nach Anspruch 1 oder einem der vorhergehenden, dadurch gekennzeichnet, daß die freien Enden (24) der Bolzen (5) bzw. (11) sich in diesen angepaßte Ausnehmungen (25) von Platten (11) erstrecken, die sich in am gegenüberliegenden Teil (1) bzw. (2) des Schrankes befestigten Aufnahmen (3) befinden.

6. Schrank nach Anspruch 1 oder einem der vorhergehenden, dadurch gekennzeichnet, daß die Aufnahmen (3) beider Teile (1, 2) des Schrankes gleich ausgebildet sind.

7. Schrank nach Anspruch 1 oder einem der vorhergehenden, dadurch gekennzeichnet, daß die Bolzen (5) bzw. (11) mindestens einer Reihe derart gestaltet sind, daß mindestens jeweils einer an verschiedenen Randbereichen der Bohrungen (26) anliegt.

**Revendications**

1. Armoire pour le classement de feuilles de montage destinées à la fabrication de planches d'impression et comportant des trous (26) qui sont placés le long de leurs bords supérieurs et par lesquels elles sont enfilées dans la position de rangement de l'armoire, sur deux rangées d'axes en porte à-faux (5, 11) disposées horizontalement et s'étendant dans un seul et même plan, les axes (5, 11) d'une rangée étant placés sur une partie fixe (1) de l'armoire et les axes de l'autre rangée sur une partie mobile (2) de l'armoire et la partie mobile (2) et la partie fixe (1) de l'armoire étant mutuellement reliés de façon télescopique, caractérisée par le fait que les guidages de la liaison télescopique sont des guidages à glissement ou à rouleaux et qu'au moins sur l'une des parties (1, 2) de l'armoire sont prévus deux ou plusieurs logements (3) de section transversale sensiblement en forme de C dans lesquels une plaque (4) ou (10), respectivement solidaire d'un des axes en porte-à-faux (5, 11), est montée avec jeu, les logements (3) étant fixés par leurs bases (16) sur les parties (1, 2) de l'armoire et comportant dans leurs branches supérieures et inférieures (17, 18) un ou plusieurs trous taraudés (19) dans lesquels sont vissées des vis (16, 9 et 13, 15) dont les faces frontales sont associées aux faces frontales supérieures et inférieures des plaques (4) ou (10), et les coudes (20, 21) des branches supérieures et inférieures (17, 21) des logements (3) étant munis d'un ou de plusieurs trous taraudés (22) dans lesquels sont vissées des vis (6) ou (12) dont les faces frontales sont associées aux faces avant des plaques (4) ou (10).

2. Armoire selon la revendication 1, caractérisée par le fait que les zones supérieures et/ou inférieures des Plaques (4 ou 10) sont traversées par des vis (8, 14) dont les têtes s'étendent avec du jeu dans des trous de passage (23) pratiqués dans les coudes (20, 21) des branches supérieures et/ou inférieures (17, 18) des logements (3).

3. Armoire selon la revendication 1 ou 2, caractérisée par le fait qu'un trou taraudé (19) est respectivement prévu en position médiane dans les branches supérieures et inférieures (17, 18) de chaque logement (3).

4. Armoire selon la revendication 1 ou l'une des précédentes, caractérisée par le fait que dans les coudes (20, 21) des branches supérieures et inférieures (17, 18) de chaque logement est respectivement prévue, en position symétrique, une paire de trous taraudés (22) entre lesquels se trouve respectivement un trou de passage (23).

5. Armoire selon la revendication 1 ou l'une des précédentes, caractérisée par le fait que les extrémités libres (2) des axes (5) ou (11) s'étendent dans des évidements (25), qui leur sont adaptés, de plaques (11) qui se trouvent dans des logements (3) fixés sur la partie opposée (1) ou (2) de l'armoire.

6. Armoire selon la revendication 1 ou l'une des précédentes, caractérisée par le fait que les logements (3) des deux parties (1, 2) de l'armoire sont réalisés identiques.

7. Armoire selon la revendication 1 ou l'une des précédentes caractérisée par le fait que les axes (5) ou (11) au moins d'une rangée sont façonnés de manière qu'au moins respectivement l'un vienne s'appliquer sur différentes zones marginales des trous (26).

**Claims**

1. A cabinet for the tidy storage of montage films for producing printing plates and which comprise perforations along their upper edge by which, when the cabinet is in the storage condition, they are pushed onto two rows of horizontally disposed freely projecting rods which extend in one and the same plane, the rods of one row being mounted on a fixed part of the cabinet while the rods of the other row are fixed on a displaceable part of the cabinet, the displaceable part and the fixed part of the cabinet being telescopically connected to each other by means of sliding or rolling guides, characterised in that at least one one of the parts (1, 2) of the cabinet there are two or more cross-sectionally substantially C-shaped housings (3) in which, with a movement clearance, there is disposed a respective plate (4) or (10) which is rigidly connected to one of the projecting rods (5) or (11), the webs (16) of the housings (3) being fixed on the parts (1, 2) of the cabinet) and having in their upper and lower arms (17, 18) one or a plurality of threaded bores (19) into which threaded rods (7, 9) or (13, 15) are screwed, the end faces of which are associated with the upper or lower end faces of the plates (4) or (10), the bent over portions (20, 21) of the upper and lower arms (17, 21) of the housings (3) being provided with one or a plurality of screwthreaded bores (22) into which are screwed threaded rods (6) or (12), the end faces of which are associated with the front sides of the plates (4) or (10).

2. A cabinet according to Claim 1, characterised in that the upper and/or lower areas of the plates (4) or (10) are traversed by screw bolts (8, 14), the heads of which extend with a movement clearance in through-bores (23) and into the bent over portions (20, 21) of the upper and/or lower arms (17, 18) of the housings (3).

3. A cabinet according to Claim 1 or 2, characterised in that a screwthreaded bore (19) is provided in the centre of each of the upper and lower arms (17, 18) of each housing (3).

4. A cabinet according to Claim 1 or one of the preceding Claims, characterised in that a pair of screwthreaded bores (22), between which there is a through bore (23), are disposed symmetrically of each other in each of the bent over portions (20, 21) of the upper and lower arms (17, 18) of each housing (3).

5. A cabinet according to Claim 1 or one of the preceding Claims, characterised in that the free ends (24) of the rods (5, 11) extend into matching cut-outs (25) in plates (11), disposed in housings fixed on the opposite part (1) or (2) respectively of the cabinet.

6. A cabinet according to Claim 1 or one of the preceding Claims, characterised in that the housings (3) in the two parts (1, 2) of the cabinet are of identical construction.

7. A cabinet according to Claim 1 or one of the preceding Claims, characterised in that the rods (5, 11) of at least one row are so constructed that in each case at least one bears on various marginal portions of the bores (26).

Fig. 1

Fig. 2

Fig. 3

Fig.6

Fig.4

Fig.5

Fig.7

Fig. 8